# EUROPÄISCHE PATENTSCHRIFT

(11) **EP 3 522 233 B1**
(45) Veröffentlichungstag und Bekanntmachung des Hinweises auf die Patenterteilung: **19.08.2020**
(21) Anmeldenummer: 19000020.8
(22) Anmeldetag: 11.01.2019
(51) Int. Cl.: H01L 29/861, H01L 29/20, H01L 29/36, H01L 21/329

(54) **STAPELFÖRMIGE III-V-HALBLEITERDIODE**
STACKED III-V SEMICONDUCTOR DIODE
DIODE À SEMI-CONDUCEUR III-V SOUS FORME D'EMPILEMENT

(30) Priorität: 18.01.2018 DE 102018000395
(43) Veröffentlichungstag der Anmeldung: 07.08.2019
(73) Patentinhaber: 3-5 Power Electronics GmbH, 01217 Dresden (DE)
(72) Erfinder: Dudek, Volker, 76275 Ettlingen (DE)
(74) Vertreter: Koch Müller Patentanwaltsgesellschaft mbH

(56) Entgegenhaltungen:
- EP-A1- 0 749 166
- EP-A2- 3 503 204
- DE-A1-102016 111 844
- A. KOEL: "Characterization of the temperature dependent behavior of snappy phenomenon by the switching-off of GaAs power diode structures", ADVANCES IN FLUID MECHANICS XI, Bd. 1, 1. Juli 2014 (2014-07-01), Seiten 439-449, XP055545469, Southampton UK ISSN: 1746-4471, DOI: 10.2495/HT140381 ISBN: 978-1-78466-105-2
- TOM SIMON ET AL: "Gallium arsenide semiconductor parameters extracted from pin diode measurements and simulations", IET POWER ELECTRONICS, Bd. 9, Nr. 4, 30. März 2016 (2016-03-30), Seiten 689-697, XP055498441, UK ISSN: 1755-4535, DOI: 10.1049/iet-pel.2015.0019

## Beschreibung

Die Erfindung betrifft eine stapelförmige III-V-Halbleiterdiode.

Aus "GaAs Power Devices" von German Ashkinazi, ISBN 965-7094-19-4, Seite 8 und 9 ist eine hochspannungsfeste Halbleiterdiode p⁺ - n - n⁺ bekannt.

Aus der EP 3 503 204 A2, aus A Koel: "Characterization of the temperature dependent behavior of snappy phenomenon by the switching-off of GaAs power diode structures", Adavances in Fluid Mechanics XI, Bd. 1, 1. Juli 2014, Seiten 439-449, XP 055545469, Southampton UK ISSN: 1746-4471, ISBN: 978-1-78466-105-2 sowie aus T. Simon et al.:"Gallium arsenide semiconductor parameters extracted from pin diode measurements and simulations", IET Power Electronics, Bd. 9, Nr. 4, 2016, 689-697, XP055498441, UK ISSN: 1755-4535, DOI: 10.1049/iet-pel.20150019 sind weitere GaAs-Diodenstrukturen bekannt.

Insbesondere ist aus dem oben genannten Paper von Koel eine stapelförmige GaAs-Diode bekannt, die ein p+-Substrat, eine p-Zwischenschicht, eine n-Schicht und eine n⁺-Schicht umfasst. Die n-Schicht besteht aus einer konstant dotierten Unterschicht und aus einer Oberschicht, deren Dotierstoffkonzentration stetig ansteigt.

Vor diesem Hintergrund besteht die Aufgabe der Erfindung darin, eine Vorrichtung anzugeben, die den Stand der Technik weiterbildet.

Die Aufgabe wird durch eine III-V-Halbleiterdiode mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine stapelförmige III-V-Halbleiterdiode, aufweisend eine n⁻-Schicht mit einer ersten Oberfläche und einer der ersten Oberfläche gegenüberliegenden zweiten Oberfläche.

Die n⁻-Schicht weist eine Dotierstoffkonzentration von 10¹²-10¹⁷ N/cm³ und eine Schichtdicke von 50 - 1000 µm von.

Die erste Oberfläche der n⁻-Schicht ist stoffschlüssig verbunden mit einer p⁺-Schicht, wobei die p⁺-Schicht eine Dotierstoffkonzentration von 5•10¹⁸-5•10²⁰ N/cm³ aufweist, oder eine Zwischenschicht zwischen der ersten Oberfläche der n⁻-Schicht und der p⁺-Schicht ausgebildet ist.

Die zweite Oberfläche der n⁻-Schicht ist stoffschlüssig verbunden mit einer n⁺-Schicht, wobei die n⁺-Schicht eine Dotierstoffkonzentration von mindestens 10¹⁹ N/cm³ aufweist.

Die p⁺-Schicht und die n⁻-Schicht und die n⁺-Schicht sind jeweils monolithisch ausgebildet und umfassen jeweils eine GaAs-Verbindung oder bestehen aus einer GaAs-Verbindung.

Die n⁺-Schicht oder die p⁺-Schicht ist als Substratschicht ausgebildet.

Die Dotierstoffkonzentration an der ersten Oberfläche der n⁻-Schicht weist einen ersten Wert und an der zweiten Oberfläche der n⁻-Schicht weist die Dotierstoffkonzentration einen zweiten Wert auf.

Der zweite Wert der Dotierstoffkonzentration ist mindestens um einen Faktor 1,5 oder mindestens um einen Faktor 2 oder mindestens um einen Faktor 2,5 größer als der erste Wert.

Es versteht sich, dass mit dem Ausdruck an der Oberfläche ein Bereich von der Oberfläche bis ca. 1,0 µm Tiefe in der betreffenden Schicht verstanden wird und es sich insbesondere bei der Dotierstoffkonzentration um eine mittlere Konzentration in dem vorgenannten Bereich handelt. Auch sei angemerkt, dass mit dem Begriff der Dotierstoffkonzentration vorliegend nur der aktivierte Teil des Dotierstoffes verstanden wird.

Nachfolgend werden die Begriffe Dotierstoffkonzentration und Dotierung synonym verwendet.

Im Unterschied zu der bisherigen Überzeugung, dass sich GaAs nämlich nur für schnelle Bauelemente mit Spannungen unterhalb von 20 V eignen oder sich GaAs für Solarzellen mit Sperrspannungen im Niedervoltbereich, d.h. unterhalb 10 Volt eignen, hat sich in sehr überraschender Weise gezeigt, dass mittels des vorgenannten Schichtaufbaus mit insbesondere der Ausführung von dicken n⁻-Schichten, d.h. Schichten oberhalb 30 µm oder vorzugsweise oberhalb 60 µm, hochsperrende Halbleiterbauelemente aus GaAs herzustellen lassen.

Weiterhin hat sich gezeigt, dass sich in überraschender Weise dicke GaAs Schichten in guter Kristallqualität einfach, schnell und kostengünstig vorzugsweise epitaktisch herstellen lassen.

Es sei angemerkt, dass vorliegenden mit dem Begriff der "hochsperrenden Bauelementen" nur Halbleiterbauelemente mit einer Sperrspannung oberhalb 100 V verstanden werden.

Die erfindungsgemäße III-V-Halbleiterdiode weist im Vergleich zu bekannten Halbleiterdioden verbesserte elektrische Eigenschaften auf. So lassen sich mit der erfindungsgemäßen III-V-Halbleiterdiode auf einfache Weise Sperrspannungen in einem Bereich von 200V - 3300 V mit kleineren Einschaltwiderständen und geringeren Kapazitäten pro Fläche als herkömmliche hochsperrende Dioden aus Si oder aus SiC herstellen. Hierdurch sind Schaltfrequenzen von 30 kHz bis zu 0,5 GHz und Stromdichten von 0,5 A/mm² bis 5 A/mm² erreichbar.

Außerdem lässt sich die erfindungsgemäße III-V-Halbleiterdioden kostengünstiger als vergleichbare hochsperrende Dioden aus SiC herstellen. Die erfindungsgemäßen III-V-Halbleiterdioden eignen sich insbesondere als Freilaufdioden.

Es sei angemerkt, dass die erfindungsgemäßen III-V-Halbleiterdioden vorliegend kleine Einschaltwiderstände in einem Bereich zwischen 1 mOhm und 200 mOhm aufweisen. Die Kapazitäten pro Fläche liegen in einem Bereich zwischen 2 pF und 100 pF.

Ein anderer Vorteil der erfindungsgemäßen III-V-Halbleiterdiode ist eine hohe Temperaturfestigkeit von bis zu 300°C. Anders ausgedrückt lassen sich die III-V-Halbleiterdioden auch in heißen Umgebungen einsetzten.

Es versteht sich, dass das Halbleiterbauelement mindestens zwei bevorzugt als Schichten ausgebildete Anschlusskontakte aufweist, wobei die Anschlusskontakte jeweils elektrisch leitfähig sind und metallische Eigenschaften aufweisen.

Bevorzugt bestehen die Anschlusskontakte⁻ aus metallisch leitfähigen Halbleiterschichten oder Metallschichten oder einer Kombination aus beiden. Die Anschlusskontakte stellen einen elektrisch niederohmigen Kontakt zu den unmittelbar angrenzenden dotierten Halbleiterschichten her.

Des Weiteren versteht es sich, dass die Anschlusskontakte vorzugsweise mittels Bonddrähte oder Lötverbindungen mit Kontaktfinger, den sogenannten Pins, verschaltet sind. Die Anschlusskontakte sind bevorzugt auf einer Oberseite bzw. einer Unterseite des aus den Halbleiterbereichen bzw. Halbleiterschichten gebildeten Stapels angeordnet.

In Beispielen, die das Verständnis der Erfindung erleichtern, weist die Dotierstoffkonzentration der n⁻-Schicht parallel zu der Schichtdicke einen stufenförmigen Verlauf von dem ersten Wert zu dem zweiten Wert auf, wobei der stufenförmige Verlauf mindestens eine Stufe umfasst.

Erfindungsgemäß weist die Dotierstoffkonzentration der n⁻-Schicht von dem ersten Wert zu dem zweiten Wert einen parallel zu der Schichtdicke der n⁻-Schicht verlaufenden stetigen Verlauf mit konstanter Steigung auf.

In einer Ausführungsform sind die drei Halbleiterschichten monolithisch ausgebildet, das heißt entweder ist die p⁺-Schicht als Substrat ausgebildet, wobei die n⁻-Schicht auf dem Substrat und die n⁺-Schicht auf der n⁻-Schicht epitaktisch erzeugt sind oder die n⁺-Schicht bildet das Substrat, wobei die n⁻-Schicht auf dem Substrat und die p⁺-Schicht auf der n⁻-Schicht epitaktisch gewachsen sind.

Gemäß einer Weiterbildung ist die p⁺-Schicht als Substrat mit einer Schichtdicke von 50-500 µm ausgebildet und die n⁺-Schicht weist eine Schichtdicke kleiner 30 µm auf. Alternativ ist die n⁺-Schicht als Substrat mit einer Schichtdicke von 50-400 µm ausgebildet und die p⁺-Schicht weist eine Schichtdicke größer 2 µm auf.

In einer anderen Weiterbildung umfasst die p⁺-Schicht Zink. Die n⁺-Schicht und/oder die n⁻-Schicht umfasst bevorzugt Chrom und/oder Silizium und/oder Palladium und/oder Zinn.

Gemäß einer weiteren Weiterbildung beträgt eine Gesamthöhe eines stapelförmigen Schichtaufbaus bestehend aus der p⁺-Schicht, der n⁻-Schicht und der n⁺-Schicht höchstens 150-500 µm.

In einer anderen Ausführungsform weist ein stapelförmiger Schichtaufbau bestehend aus der p⁺-Schicht, der n⁻-Schicht und der n⁺-Schicht eine rechteckige oder quadratische Oberfläche mit Kantenlängen zwischen 1 mm und 10 mm auf Alternativ weist der stapelförmiger Schichtaufbau eine ovale oder kreisförmige Oberfläche auf.

In einer weiteren Ausführungsform weist der stapelförmige Schichtaufbau bestehend aus der p⁺-Schicht, gegebenfalls der optionalen der Zwischenschicht, der n⁻-Schicht und der n⁺-Schicht einen zwischen der n⁻-Schicht und der Zwischenschicht oder der n⁻-Schicht und dem p⁺-Substrat ausgebildeten Halbleiterbond auf.

Es wird angemerkt, dass der Ausdruck Halbleiterbond synonym mit dem Ausdruck Waferbond verwendet wird.

Der Schichtaufbau bestehend aus der p⁺-Schicht und gegebenfalls der optionalen Zwischenschicht bildet einen ersten Teilstapel aus.

Der Schichtaufbau bestehend aus der n⁺-Schicht eine der n⁻-Schicht bildet einen zweiten Teilstapel. Der erste Teilstapel und der zweite Teilstapel sind vorzugsweise jeweils monolithisch ausgebildet.

In einer Weiterbildung wird der erste Teilstapel gebildet, in dem ausgehend von einem p⁺-Substrat gegebenenfalls mittels Epitaxie die optionale Zwischenschicht hergestellt wird.

Vorzugsweise weist die als p⁻-Schicht ausgebildete Zwischenschicht eine Dotierung kleiner als 10¹³ N/cm⁻³ oder eine Dotierung zwischen 10¹³ N/cm⁻³ und 10¹⁵ N/cm⁻³ auf.

In einer Ausführungsform wird das p⁺-Substrat vor oder nach dem Bonden durch einen Schleifprozess auf eine Dicke zwischen 200 µm und 500 µm gedünnt.

In einer Ausführungsform wird der zweite Stapel gebildet, in dem ausgehend von einem n⁻-Substrat, das n⁻-Substrat mit dem zweiten Stapel durch einen Waferbondprozess verbunden wird.

In einem weiteren Prozessschritt wird das n⁻-Substrat auf die gewünschte Dicke gedünnt. Vorzugsweise liegt die Dicke des n⁻-Substrats in einem Bereich zwischen 50 µm bis 250µm.

Vorzugsweise liegt die Dotierung des n⁻-Substrats in einem Bereich zwischen 10¹³ N/cm⁻³ und 10¹⁵ N/cm⁻³. Ein Vorteil des Waferbondens ist es, dass sich auch sehr dicke n⁻-Schichten oberhalb 50 µm ohne weiteres herstellen lassen. Ein langer Abscheideprozess bei der Epitaxie entfällt hierdurch. Auch lassen sich mittels des Waferbondens die Anzahl der Stapelfehler verringern.

In eine alternativen Ausführungsform weist das n⁻-Substrat eine Dotierung größer als 10¹⁰ N/cm⁻³ und kleiner als 10¹³ N/cm⁻³ auf. In dem die Dotierung hierbei extrem gering ist, lässt sich das n⁻-Substrat in der vorgenannten Ausführungsform auch als eine intrinsische Schicht auffassen.

In einer Weiterbildung wird nach dem Dünnen des n⁻-Substrats mittels Epitaxie oder Hochdosisimplantation auf dem n⁻-Substrat die n⁺-Schicht in einem Bereich zwischen 10¹⁸ N/cm⁻³ und kleiner als 5x10¹⁹ N/cm⁻³ erzeugt. Das Dünnen des n⁻-Substrats erfolgt vorzugsweise mittels eines CMP Schrittes, d.h. mittels chemischen mechanischen Polierens.

In einer anderen Weiterbildung wird auf der Vorderseite der Dioden-Struktur eine Hilfsschicht aufgetragen. Anschließend lässt die Rückseite der Dioden-Struktur dünnen und auf einem Träger ablegen. In einer anderen Weiterbildung wird anschließend die Vorderseite abgelöst.

In einer Ausführungsform werden die Oberfläche des n⁺-Substrats und die Oberfläche des p⁺-Substrats metallisiert, um die Halbleiter-Diode elektrisch anzuschließen. Vorzugsweise wird die Kathode der Halbleiter-Diode nach der Metallisierung mit einer als Wärmesenke ausgebildeten Unterlage stoffschlüssig verbunden. Anders ausgedrückt, die Anode ist an der Oberfläche der Diode auf der p⁺-Schicht ausgebildet.

Untersuchungen haben gezeigt, dass sich mit bestimmten Kombinationen von einer p⁻- Zwischenschicht und n⁻-Schicht verschiedene Sperrspannungen erzielen lassen.

In einer ersten Variante umfasst die:
p⁻- Zwischenschicht eine Dicke zwischen 10 µm bis 25 µm, die n⁻-Schicht eine Dicke zwischen 40 µm und 90 µm, wobei sich eine Sperrspannung von ca. 900 V ergibt.

In einer zweiten Variante umfasst die:
p⁻- Zwischenschicht eine Dicke zwischen 25 µm bis 35 µm, die n⁻-Schicht eine Dicke zwischen 40 µm und 70 µm, wobei sich eine Sperrspannung von ca. 1200 V ergibt.

In einer dritten Variante umfasst die:
p⁻- Zwischenschicht eine Dicke zwischen 35 µm bis 50 µm, die n⁻-Schicht eine Dicke zwischen 70 µm und 150 µm, wobei sich eine Sperrspannung von ca. 1500 V ergibt.

Die Dioden in der ersten bis dritten Variante werden auch als sogenannte Punsch- Dioden bezeichnet.

In einer vierten Variante umfasst die:
p⁻- Zwischenschicht eine Dicke zwischen 10 µm bis 25 µm, die n⁻-Schicht eine Dicke zwischen 60 µm und 110 µm.

In einer fünften Variante umfasst die:
p⁻- Zwischenschicht eine Dicke zwischen 10 µm bis 25 µm, die n⁻-Schicht eine Dicke zwischen 70 µm) und 140.

In einer sechsten Variante umfasst die:
p⁻- Zwischenschicht eine Dicke zwischen 35 µm bis 50 µm, die n⁻-Schicht eine Dicke zwischen 80µm und 200 µm.

Die Dioden in der vierten bis sechsten Variante werden auch als "non - reach - through" - Dioden bezeichnet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1: eine schematische Ansicht einer stapelförmigen III-V-Halbleiterdiode,
- Figur 2: eine schematische Aufsicht einer stapelförmigen III-V-Halbleiterdiode,
- Figur 3: eine schematische Ansicht einer Dotierstoffkonzentration über eine Schichtdicke einer n⁻-Schlcht einer Halbleiterdiode gemäß eines Beispiels, das das Verständnis der Erfindung erleichtert,

- Figur 4: eine schematische Ansicht einer erfindungsgemäßen Ausführungsform einer Dotierstoffkonzentration über eine Schichtdicke einer n⁻-Schicht einer erfindungsgemäßen Halbleiterdiode.

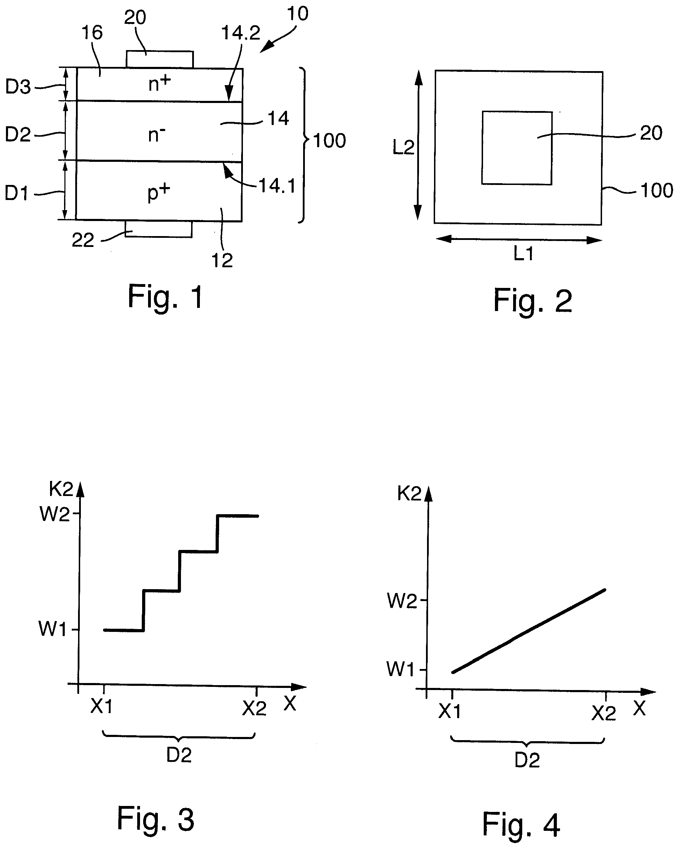

Die Abbildungen der Figuren 1 und 2 zeigen eine seitliche Ansicht und eine Aufsicht einer migen III-V-Halbleiterdiode 10. Die Halbleiterdiode 10 weist einen drei Halbleiterschichten umfassenden Stapel 100 sowie eine erste Kontaktschicht 20 und eine zweite Kontaktschicht 22 auf.

Die erste Halbleiterschicht ist eine als Substrat ausgebildete p⁺-Schicht 12 mit einer Oberseite, einer Unterseite und einer Dotierstoffkonzentration von 5•10¹⁸-5•10²⁰ N/cm³. Die zweite Halbleiterschicht ist eine n⁻-Schicht 14 mit einer ersten Oberfläche 14.1, einer der ersten Oberfläche gegenüberliegenden zweiten Oberfläche 14.2, einer Dotierstoffkonzentration von 10¹²-10¹⁷ N/cm³ und einer Schichtdicke D2 von 50 - 1000 µm. Die dritte Halbleiterschicht ist eine n⁺-Schicht 16 mit einer Oberseite, einer Unterseite und einer Dotierstoffkonzentration von mindestens 10¹⁹ N/cm³.

Eine optionale vorzugsweise als p⁻-Schicht ausgebildete Zwischenschicht ist nicht dargestellt. Die optionale Zwischenschicht ist zwischen der n⁻-Schicht 14 und der p⁺-Schicht 12 ausgebildet.

Die drei Halbleiterschichten umfassen eine GaAs-Verbindung oder bestehen aus einer GaAs-Verbindung. Alternativ ist die n⁺-Schicht 16 als Substrat ausgebildet, auf der erst die n⁻-Schicht 14 und dann die p⁺-Schicht erzeugt werden.

Die erste Kontaktschicht 20 ist auf einer Oberseite der n⁺-Schicht 16, also auf einer Oberseite des Stapels 100 angeordnet und mit der n⁺-Schicht 16 stoffschlüssig und elektrisch leitfähig verbunden.

Die zweite Kontaktschicht 22 ist auf einer Unterseite der p⁺-Schicht 12, also auf einer Unterseite des Stapels 100 angeordnet und mit der p⁺-Schicht 12 stoffschlüssig und elektrisch leitfähig verbunden.

Der aus den drei Halbleiterschichten bestehende Stapel 100 weist einen rechteckigen Umfang mit einer ersten Kantenlänge L1 und einer zweiten Kantenlänge L2 auf. Die Kontaktschichten 20 und 22 sind gemäß dem dargestellten Ausführungsbeispiel ebenfalls rechteckig und mit kleineren Kantenlängen ausgebildet. Die n+Schicht 16 umschließt die erste Kontaktschicht 20 und überdeckt ganz oder teilweise die n⁻-Schicht 14.

Die p⁺-Schicht 12 weist eine Dotierstoffkonzentration K1 auf, wobei die Dotierstoffkonzentration K1 innerhalb der gesamten Schicht einen im Wesentlichen konstanten Wert im Bereich von 5•10¹⁸-5•10²⁰ N/cm³ aufweist.

Die n⁺-Schlcht 12 weist eine Dotierstoffkonzentration K3 auf, die ebenfalls einen innerhalb der gesamten Schicht im Wesentlichen konstanten Wert aufweist. Der Wert der Dotierstoffkonzentration K3 der n⁺-Schicht 12 beträgt mindestens 10¹⁹ N/cm³.

Die n⁻-Schicht 14 weist dagegen eine sich ändernde Dotierstoffkonzentration K2 auf. Die Dotierstoffkonzentration K2 der n⁻-Schicht 14 weist an der an die p⁺-Schicht 12 angrenzenden ersten Oberfläche 14.1 der n⁻-Schicht 14 einen ersten Wert W1 und an einer an die n⁺-Schicht (14) angrenzenden zweiten Oberfläche 14.2 der n⁻-Schicht 14 einen zweiten Wert W2 auf, wobei sowohl der erste Wert W1 als auch der zweite Wert W2 in einem Bereich von 10¹²-10¹⁷ N/cm³ liegen und der zweite Wert W2 der Dotierstoffkonzentration K2 mindestens um einen Faktor zwischen 1,5 und 2,5 größer als der erste Wert W1 ist. Die Dotierstoffkonzentration K2 der n⁻-Schicht 14 steigt also entlang der Schichtdicke D2 der n⁻-Schicht 14 an.

In der Abbildung der Figur 3 ist ein Verlauf der Dotierstoffkonzentration K2 der n⁻-Schicht 14 parallel zu der Schichtdicke D2 der n⁻-Schicht 14 gemäß eines nicht erfindungsgemäßen Beispiels schematisch dargestellt. Die Dotierstoffkonzentration K2 der n⁻-Schicht 14 weist an der ersten Oberfläche 14.1, deren Position als x1 bezeichnet wird, den ersten Wert W1 und an der zweiten Oberfläche 14.2, deren Position mit x2 bezeichnet wird, den zweiten Wert W2 auf. Zwischen der ersten Oberfläche 14.1 und der zweiten Oberfläche 14.2 bzw. zwischen den Positionen x1 und x2 steigt die Dotierstoffkonzentration K2 stufenförmig an, d.h. die Dotierstoffkonzentration K2 weist einen stufenförmigen Verlauf auf, wobei der stufenförmige Verlauf im dargestellten Beispiel drei Stufen umfasst.

Beispielsweise beträgt der erste Wert W1 5•10¹⁴ N/cm³, der zweite Wert W2 1•10¹⁶ N/cm³.

In der Abbildung der Figur 4 ist ein Verlauf der Dotierstoffkonzentration K2 der n⁻-Schicht 14 parallel zu der Schichtdicke D2 der n⁻-Schicht 14 gemäß einer erfindungsgemäßen Ausführungsform schematisch dargestellt.

Die Dotierstoffkonzentration steigt zwischen dem ersten Wert W1 und dem zweiten Wert W2 entlang der Schichtdicke D2 stetig und mit einer konstanten Steigung an, d.h. die Dotierstoffkonzentration K2 der n⁻-Schicht 14 weist einen stetigen Verlauf mit konstanter Steigung auf.

## Patentansprüche

1. Stapelförmige III-V-Halbleiterdiode (10), aufweisend
- eine n⁻-Schicht (14) mit einer ersten Oberfläche (14.1), einer der ersten Oberfläche gegenüberliegenden zweiten Oberfläche (14.2), einer Dotierstoffkonzentration (K2) von 10¹²-10¹⁷ N/cm³ und einer Schichtdicke (D2) von 50 - 1000 µm,
- eine p⁺-Schlcht (12), die eine Dotierstoffkonzentration (K1) von 5•10¹⁸-5•10²⁰ N/cm³ aufweist, wobei entweder die p⁺-Schicht stoffschlüssig mit der ersten Oberfläche (14.1) der n ⁻-Schicht verbunden ist, oder eine p⁻-Zwischenschicht zwischen der n⁻-Schicht und der p⁺-Schicht angeordnet ist,
- eine stoffschlüssig mit der zweiten Oberfläche (14.2) der n⁻-Schicht (14) verbundene n⁺-Schicht (16) mit einer Dotierstoffkonzentration (K3) von mindestens 10¹⁹ N/cm³, wobei
- die p⁺-Schicht (12), die n⁻-Schicht (14) und die n⁺-Schicht (16) jeweils monolithisch ausgebildet sind und jeweils eine GaAs-Verbindung umfassen oder aus einer GaAs-Verbindung bestehen und
- die n⁺-Schicht (16) oder die p⁺-Schicht (12) als Substratschicht ausgebildet Ist,
- die Dotierstoffkonzentration (K2) der n⁻-Schicht (14) an der in Richtung der p⁺-Schicht (12) ausgebildeten ersten Oberfläche (14.1) einen ersten Wert (W1) und an der an die n⁺-Schicht (14) angrenzenden zweiten Oberfläche (14.2) einen zweiten Wert (W2) aufweist, wobei
- der zweite Wert (W2) der Dotierstoffkonzentration (K2) mindestens um einen Faktor 1,5 oder mindestens um einen Faktor 2 oder mindestens um einen Faktor 2,5 größer als der erste Wert (W1) ist,
- die Dotierstoffkonzentration (K2) der n⁻-Schicht (14) von dem ersten Wert (W1) zu dem zweiten Wert (W2) parallel zu der Schichtdicke (D2) der n⁻-Schicht (14) einen stetigen Verlauf aufweist, wobei der stetige Verlauf eine konstante Steigung aufweist.

2. Stapelförmige III-V-Halbleiterdiode (10) nach Anspruch 1, **dadurch gekennzeichnet, dass** die p⁺-Schicht (12) als Substrat mit einer Schichtdicke (D1) von 50-500 µm ausgebildet ist und die n⁺-Schicht (16) eine Schichtdicke (D3) kleiner 30 µm aufweist.

3. Stapelförmige III-V-Halbleiterdiode (10) nach Anspruch 1, **dadurch gekennzeichnet, dass** die n⁺-Schicht (16) als Substrat mit einer Schichtdicke (D3) von 50-400 µm ausgebildet ist und die p⁺-Schicht (12) eine Schichtdicke (D1) größer 2 µm aufweist.

4. Stapelförmiges III-V-Halbleiterbauelement (10) nach einem der Ansprüche 1 bis 3, **dadurch gekennzeichnet, dass** die p⁺-Schicht (12) Zink umfasst.

5. Stapeiförmiges III-V-Halbleiterbauelement (10) nach einem der Ansprüche 1 bis 4, **dadurch gekennzeichnet, dass** die n⁺-Schicht (16) und/oder die n⁻-Schicht (14) Chrom und/oder Silizium und/oder Palladium und/oder Zinn umfasst.

6. Stapelförmige III-V-Halbleiterdiode (10) nach einem der Ansprüche 1 bis 5, **dadurch gekennzeichnet, dass** eine Gesamthöhe eines stapelförmigen Schichtaufbaus (100) bestehend aus der p⁺-Schicht (12), der n⁻-Schicht (16) und der n⁺-Schicht (16) höchstens 150-500 µm beträgt.

7. Stapelförmige III-V- Halbleiterdiode (10) nach einem der Ansprüche 1 bis 6, **dadurch gekennzeichnet, dass** ein stapelförmiger Schichtaufbau (100) bestehend aus der p⁺-Schicht (12), der n⁻-Schicht (16) und der n⁺-Schicht (16) eine rechteckige oder quadratische Oberfläche mit Kantenlängen (L1, L2) zwischen 1 mm und 10 mm aufweist, wobei die n⁺ - Schicht 16 eine erste Kontaktschicht 20 überdeckt und die n⁻-Schicht ganz oder teilweise die n⁺-Schicht überdeckt.

8. Stapelförmige III-V- Halbleiterdiode (10) nach einem der Ansprüche 1 bis 6, **dadurch gekennzeichnet, dass** ein stapelförmiger Schichtaufbau (100) bestehend aus der p⁺-Schicht (12), der n⁻-Schicht (16) und der n⁺-Schicht (16) eine ovale oder kreisförmige Oberfläche aufweist, wobei die n⁺ -Schicht 16 eine erste Kontaktschicht 20 überdeckt und die n⁻-Schicht ganz oder teilweise die n⁺-Schicht überdeckt.

9. Stapelförmige III-V- Halbleiterdiode (10) nach einem der Ansprüche 1 bis 5, **dadurch gekennzeichnet, dass** zwischen der p⁺-Schicht (12) und der n⁻-Schicht (16) eine Zwischenschicht ausgebildet ist.

10. Stapelförmige III-V- Halbleiterdiode (10) nach einem der Ansprüche 1 bis 5 oder 9, **dadurch gekennzeichnet, dass** zwischen der p⁺-Schicht (12) und der n⁻-Schicht (16) oder zwischen der Zwischenschicht und der n⁻-Schicht (16) ein Halbleiterbond ausgebildet ist.

## Claims

1. Stack-shaped III-V semiconductor diode (10), comprising
- an n⁻ layer (14) with a first surface (14.1), a second surface (14.2) opposite the first surface, a doping substance concentration (K2) of 10¹² - 10¹⁷ N/cm³ and a layer thickness (D2) of 50 - 1,000 µm,
- a p⁺ layer (12), which has a doping substance concentration (K1) of 5.10¹⁸ - 5.10²⁰ N/cm³, wherein either the p⁺ layer is connected by material couple with the first surface (14.1) of the n⁻ layer or a p⁻ intermediate layer is arranged between the n⁻ layer and the p⁺ layer,
- an n⁺ layer (16), which is connected with the second surface (14.2) of the n⁻ layer (14) by material couple, with a doping substance concentration (K3) of at least 10¹⁹ N/cm³, wherein
- the p⁺ layer (12), the n⁻ layer (14) and the n⁺ layer (16) are each of monolithic construction and each comprise a GaAs compound or consist of a GaAs compound and
- the n⁺ layer (16) or the p⁺ layer (12) is constructed as a substrate layer,
- the doping substance concentration (K2) of the n⁻ layer (14) at the first surface (14.1), which is formed in the direction of the p⁺ layer (12), has a first value (W1) and at the second surface (14.2), which adjoins the n⁺ layer (14), has a second value (W2), wherein
- the second value (W2) of the doping substance concentration (K2) is larger than the first value (W1) by at least a factor of 1.5 or by at least a factor of 2 or by at least a factor of 2.5,
- the doping substance concentration (K2) of the n' layer (14) has a constant course from the first layer (W1) to the second layer (W2) parallel to the layer thickness (D2) of the n⁻ layer (14),
wherein the constant course has a constant gradient.

2. Stack-shaped III-V semiconductor diode (10) according to claim 1, **characterised in that** the p⁺ layer (12) is constructed as a substrate with a layer thickness (D1) of 50 - 500 µm and the n⁺ layer (16) has a layer thickness (D3) smaller than 30 µm.

3. Stack-shaped III-V semiconductor diode (10) according to claim 1, **characterised in that** the n⁺ layer (16) is constructed as a substrate with a layer thickness (D3) of 50 - 400 µm and the p⁺ layer (12) has a layer thickness (D1) larger than 2 µm.

4. Stack-shaped III-V semiconductor diode (10) according to any one of claims 1 to 3, **characterised in that** the p⁺ layer (12) comprises zinc.

5. Stack-shaped III-V semiconductor diode (10) according to any one of claims 1 to 4, **characterised in that** the n⁺ layer (16) and/or the n⁻ layer (14) comprises chromium and/or silicon and/or palladium and/or tin.

6. Stack-shaped III-V semiconductor diode (10) according to any one of claims 1 to 5, **characterised in that** an overall height of the stack-shaped layer construction (100) consisting of the p⁺ layer (12), the n⁻ layer (16) and the n⁺ layer (16) is at most 150 - 500 µm.

7. Stack-shaped III-V semiconductor diode (10) according to any one of claims 1 to 6, **characterised in that** a stack-shaped layer construction (100) consisting of the p⁺ layer (12), the n⁻ layer (16) and the n⁺ layer (16) has a rectangular or square surface with edge lengths (L1, L2) between 1 mm and 10 mm, wherein the n⁺ layer (16) covers a first contact layer (20) and the n⁻ layer entirely or partly covers the n⁺ layer.

8. Stack-shaped III-V semiconductor diode (10) according to any one of claims 1 to 6, **characterised in that** a stack-shaped layer construction (100) consisting of the p⁺ layer (12), the n⁻ layer (16) and the n⁺ layer (16) has an oval or circular surface, wherein the n⁺ layer (16) covers a first contact layer (20) and the n⁻ layer entirely or partly covers the n⁺ layer.

9. Stack-shaped III-V semiconductor diode (10) according to any one of claims 1 to 5, **characterised in that** an intermediate layer is formed between the p⁺ layer (12) and the n⁻ layer (16).

10. Stack-shaped III-V semiconductor diode (10) according to any one of claims 1 to 5 and 9, **characterised in that** a semiconductor bond is formed between the p⁺ layer (12) and the n⁻ layer (16) or between the intermediate layer and the n⁻ layer (16).

## Revendications

1. Diode à semi-conducteur III-V sous forme d'empilement (10), présentant :
- une couche n⁻ (14) qui présente une première surface (14.1), une deuxième surface (14.2) située à l'opposé de la première surface, une concentration de substances dopantes (K2) comprise entre 10¹² N/cm³ et 10¹⁷ N/cm³ et une épaisseur de couche (D2) comprise entre 50 µm et 1000 µm, et
- une couche p⁺ (12), qui présente une concentration de substances dopantes (K1) comprise entre 5*10¹⁸ N/cm³ et 5*10²⁰ N/cm³,
dans laquelle soit la couche p⁺ est assemblée matériellement à la première surface (14.1) de la couche n⁻, soit une couche intermédiaire p⁻ est disposée entre la couche n⁻ et la couche p⁺,
- une couche n⁺ (16) assemblée matériellement à la deuxième surface (14.2) de la couche n⁻ (14) et qui présente une concentration de substances dopantes (K3) d'au moins 10¹⁹N/cm³, dans laquelle
- la couche p⁺ (12), la couche n⁻ (14) et la couche n⁺ (16) sont réalisées respectivement sous forme monolithique et comprennent chacune un composé GaAs ou sont constituées d'un composé GaAs, et
- la couche n⁺ (16) ou la couche p⁺ (12) est formée par une couche de substrat,
- la concentration de substances dopantes (K2) de la couche n⁻ (14) présente sur la première surface (14.1) formée en direction de la couche p⁺ (12) une première valeur (W1) et sur la deuxième surface (14.2) adjacente à la couche n⁺ (14) une deuxième valeur (W2), dans laquelle
- la deuxième valeur (W2) de la concentration de substances dopantes (K2) est supérieure à la première valeur (W1) d'au moins un facteur 1,5 ou d'au moins un facteur 2 ou d'au moins un facteur 2,5,
- la concentration de substances dopantes (K2) de la couche n⁻ (14) présente une allure constante de la première valeur (W1) à la deuxième valeur (W2) parallèlement à l'épaisseur de couche (D2) de la couche n⁻ (14),
dans laquelle l'allure constante présente une pente constante.

2. Diode à semi-conducteur III-V sous forme d'empilement (10) selon la revendication 1, **caractérisée en ce que** la couche p⁺ (12) est formée par un substrat qui présente une épaisseur de couche (D1) comprise entre 50 µm et 500 µm et la couche n⁺ (16) présente une épaisseur de couche (D3) inférieure à 30 µm.

3. Diode à semi-conducteur III-V sous forme d'empilement (10) selon la revendication 1, **caractérisée en ce que** la couche n⁺ (16) est formée par un substrat qui présente une épaisseur de couche (D3) comprise entre 50 µm et 400 µm et la couche p⁺ (12) présente une épaisseur de couche (D1) supérieure à 2 µm.

4. Composant à semi-conducteur III-V sous forme d'empilement (10) selon l'une quelconque des revendications 1 à 3, **caractérisé en ce que** la couche p⁺ (12) comprend du zinc.

5. Composant à semi-conducteur III-V sous forme d'empilement (10) selon l'une quelconque des revendications 1 à 4, **caractérisé en ce que** la couche n⁺ (16) et/ou la couche n⁻ (14) comprend(-nent) du chrome et/ou du silicium et/ou du palladium et/ou de l'étain.

6. Diode à semi-conducteur III-V sous forme d'empilement selon l'une quelconque des revendications 1 à 5, **caractérisée en ce que** la hauteur totale d'une structure stratifiée sous forme d'empilement (100) se composant de la couche p⁺ (12), de la couche n⁻ (16) et de la couche n⁺ (16) vaut au maximum de 150 µm à 500 µm.

7. Diode à semi-conducteur III-V sous forme d'empilement (10) selon l'une quelconque des revendications 1 à 6, **caractérisée en ce qu'**une structure stratifiée sous forme d'empilement (100) se composant de la couche p⁺ (12), de la couche n⁻ (16) et de la couche n⁺ (16) présente une surface rectangulaire ou carrée avec des longueurs de côté (L1, L2) comprises entre 1 mm et 10 mm, dans laquelle la couche n⁺ (16) recouvre une première couche de contact (20) et la couche n⁻ recouvre entièrement ou partiellement la couche n⁺.

8. Diode à semi-conducteur III-V sous forme d'empilement (10) selon l'une quelconque des revendications 1 à 6, **caractérisée en ce qu'**une structure stratifiée sous forme d'empilement (100) se composant de la couche p⁺ (12), de la couche n-(16) et de la couche n⁺ (16) présente une surface ovale ou circulaire, dans laquelle la couche n⁺ (16) recouvre une première couche de contact (20) et la couche n⁻ recouvre entièrement ou partiellement la couche n⁺.

9. Diode à semi-conducteur III-V sous forme d'empilement (10) selon l'une quelconque des revendications 1 à 5, **caractérisée en ce qu'**une couche intermédiaire est formée entre la couche p⁺ (12) et la couche n⁻ (16).

10. Diode à semi-conducteur III-V sous forme d'empilement (10) selon l'une quelconque des revendications 1 à 5 ou 9, **caractérisée en ce qu'**une liaison à semi-conducteur est formée entre la couche p⁺ (12) et la couche n⁻ (16) ou entre la couche intermédiaire et la couche n⁻ (16).
